# EUROPEAN PATENT SPECIFICATION

(11) **EP 3 032 933 B1**
(45) Date of publication and mention of the grant of the patent: **19.09.2018**
(21) Application number: 13891008.8
(22) Date of filing: 07.08.2013
(51) Int. Cl.: G01B 11/00, H05K 13/04, H05K 13/08, G01N 21/956

(54) **ELECTRONIC COMPONENT MOUNTING MACHINE AND TRANSFER CONFIRMATION METHOD**
ELEKTRONISCHE BAUTEILBESTÜCKUNGSEINRICHTUNG UND ÜBERTRAGUNGSBESTÄTIGUNGSVERFAHREN
MACHINE DE MONTAGE DE COMPOSANT ÉLECTRONIQUE ET PROCÉDÉ DE CONFIRMATION DE TRANSFERT

(43) Date of publication of application: 15.06.2016
(73) Proprietor: Fuji Machine Mfg. Co., Ltd., Chiryu-shi Aichi 472-8686 (JP)
(72) Inventor: YAMADA, Kazunori, Chiryu-shi Aichi 472-8686 (JP)
(74) Representative: Grünecker Patent- und Rechtsanwälte PartG mbB
(86) International application number: PCT/JP2013/071381
(87) International publication number: WO 2015/019447

(56) References cited:
- WO-A1-99/00661
- JP-A- H1 075 096
- JP-A- H1 075 096
- JP-A- 2003 008 300
- JP-A- 2003 008 300
- JP-U- S6 242 281
- JP-U- S6 242 281

## Description

### Technical Field

The present invention relates to an electronic component mounting machine which mounts an electronic component, to the electrodes of which a viscous fluid is transferred, on a circuit board, and relates to a transfer confirmation method which confirms the transfer state of the viscous fluid onto the electrodes of the electronic component.

### Background Art

JP-A-2007-258398 discloses an electronic component mounting machine which is provided with a mounting head which holds an electronic component and a viscous fluid tray which stores a viscous fluid, in which the viscous fluid is transferred to the electrodes of the electronic component which is held by the mounting head, and the electronic component is mounted on the circuit board. In such an electronic component mounting machine, when the transferring of the viscous fluid to the electrodes is not appropriately performed, the electronic component may not be appropriately mounted on the circuit board. Therefore, in the electronic component mounting machine described in the patent literature described below, transfer confirmation of the viscous fluid to the electrodes is performed using an imaging camera.

Specifically, the electrodes before the viscous fluid is transferred are imaged from below by the imaging camera, and the diameters of the electrodes are calculated based on the imaging data. The electrodes after the viscous fluid is transferred are imaged from below by the imaging camera, and the diameters of the electrodes are calculated based on the imaging data. The diameters of the electrodes before and after the transferring of the viscous fluid are compared, and the transfer confirmation of the viscous fluid to the electrodes is performed. In other words, when the diameters of the electrodes after the transferring of the viscous fluid are greater than the diameters of the electrodes before the transferring of the viscous fluid, it is determined that the viscous fluid is transferred to the electrodes.

JP-A-H10-75096 discloses an electronic component mounting machine according to the preamble of independent claim 1, which is intended to improve the quality of junction with a printed board by easily measuring the shape and the quantity, respectively, of the bump made at the electrode of a flip chip part and the conductive adhesive at the top of the bump, in a mounter for the flip chip part. This mounter is equipped with a CCD camera which picks up the image of the side face form of a bump, and the first image processor and the second image processor which operate the height and width of the bump and the semicircular form of the bump from the side face form of the bump before and after the transcription of a conductive adhesive photographed by the CCD camera, and the quantity of transcription of the conductive adhesive is measured from the computation data of the second image processor and the computation data of the first image processor, and when the quantity of this transcription fulfills the preset tolerance, this flip chip part is mounted on a printed board. Therefore, when mounting the flip chip part on the printed board, the quality of junction can be improved.

### Summary of Invention

### Technical Problem

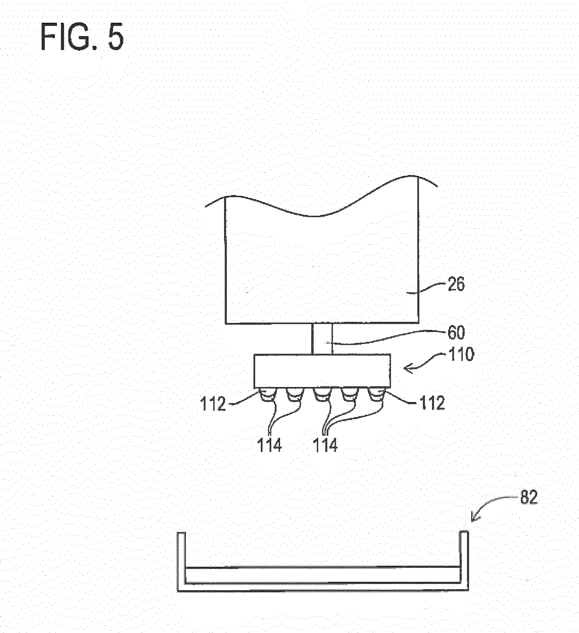

According to the electronic component mounting machine described in the patent literature described above, to a certain extent, it is possible to confirm the transferring of the viscous fluid to the electrodes. However, there is a case in which the viscous fluid which is transferred to the electrodes moves to the distal end portions of the electrodes due to gravity (refer to Fig. 5). In this case, even if the viscous fluid is transferred to the electrodes, the diameters of the electrodes barely increase in size in the viewpoint from below. In other words, even though the viscous fluid is transferred to the electrodes, the diameter of the electrodes after the transferring of the viscous fluid and the diameter of the electrodes before the transferring of the viscous fluid are approximately the same based on the imaging data, and the transfer confirmation of the viscous fluid to the electrodes may not be appropriately performed. The imaging data is converted to data using an image processing method such as grayscaling, and the determination of the quality of the transferring is performed. However, since many of the viscous fluids have high transparency, it is difficult to distinguish the electrodes from the viscous fluid in the grayscaling method. It is necessary to adjust the imaging conditions such as the lighting and the shutter speed of the imaging camera finely and frequently such that the contrast becomes clear. The present invention was made in light of these issues, and an object thereof is to provide an electronic component mounting machine and a transfer confirmation method which are capable of appropriately and simply performing the transfer confirmation of the viscous fluid to the electrodes, even when the viscous fluid moves to the distal end portions of the electrodes.

### Solution to Problem

In order to solve the problem described above, according to claim 1 of the present application, there is provided an electronic component mounting machine which mounts an electronic component, to an electrode of which a viscous fluid is transferred, on a circuit board, the electronic component mounting machine including a mounting head which holds the electronic component, and a viscous fluid tray for storing the viscous fluid and transferring the viscous fluid to the electrode of the electronic component which is held by the mounting head, in which the electronic component mounting machine includes a height sensor capable of detecting a height of the electrode of the electronic component which is held by the mounting head, an electrode height detection section which detects a pre-transfer electrode height which is the height of the electrode before transferring of the viscous fluid and a post-transfer electrode height which is the height of the electrode after transferring of the viscous fluid using the height sensor, and a transfer state confirmation section which confirms a transfer state of the viscous fluid to the electrode by comparing the pre-transfer electrode height and the post-transfer electrode height which are detected by the electrode height detection section.

For the electronic component mounting machine according to claim 2, in the electronic component mounting machine according to claim 1, the height sensor is a line sensor including an irradiation section which irradiates a measurement target with light in a linear manner, and a light receiving section which receives the light which irradiates the measurement target from the irradiation section and is reflected by the measurement target.

For the electronic component mounting machine according to claim 3, in the electronic component mounting machine according to claim 1 or claim 2, the height sensor is a sensor for performing a coplanarity check on the electronic component.

In a transfer confirmation method according to claim 4 which confirms a transfer state of a viscous fluid to an electrode in an electronic component mounting machine which mounts an electronic component, to the electrode of which a viscous fluid is transferred, on a circuit board, the electronic component mounting machine includes a mounting head which holds the electronic component, and a viscous fluid tray for storing the viscous fluid and transferring the viscous fluid to the electrode of the electronic component which is held by the mounting head, in which the transfer confirmation method includes a pre-transfer electrode height detection step of detecting a height of the electrode before transferring of the viscous fluid using a height sensor capable of detecting the height of the electrode of the electronic component which is held by the mounting head, a post-transfer electrode height detection step of detecting the height of the electrode after transferring of the viscous fluid using the height sensor, and a transfer confirmation step of confirming the transfer state of the viscous fluid to the electrode by comparing the height of the electrode which is detected in the pre-transfer electrode height detection step and the height of the electrode which is detected in the post-transfer electrode height detection step.

### Advantageous Effects of Invention

In the electronic component mounting machine according to claim 1 and the transfer confirmation method according to claim 4, the height of the electrode before the transferring of the viscous fluid and the height of the electrode after the transferring of the viscous fluid are detected by the height sensor, and the transferring of the viscous fluid to the electrode is confirmed by comparing the height of the electrode before the transferring of the viscous fluid and the height of the electrode after the transferring of the viscous fluid. Accordingly, even when the viscous fluid moves to the distal end portion of the electrode and the diameter of the electrode barely changes between before and after the transferring, it is possible to appropriately perform the transfer confirmation of the viscous fluid to the electrode.

In the electronic component mounting machine according to claim 2, a line sensor is adopted as the height sensor which detects the height of the electrode. The line sensor generally irradiates a measurement location with high frequency laser light, the resolution is high, and it is possible to distinguish heights or recessions and protrusions at a high resolution. Therefore, by using the line sensor, it is possible to perform the transfer confirmation of the viscous fluid to the electrode with extremely high precision.

In the electronic component mounting machine according to claim 3, a sensor which is used when performing the coplanarity check is adopted as the height sensor which detects the height of the electrode. In many electronic component mounting machines, a coplanarity check is performed for determining the planarity of the electrodes of the electronic component, that is, whether or not the heights of the electrodes are uniform. Therefore, in many electronic component mounting machines, a height sensor is provided for performing the coplanarity check. In the electronic component mounting machine according to claim 3, the height sensor is also used to perform the transfer confirmation of the viscous fluid to the electrodes. Accordingly, it is not particularly necessary to provide a sensor for performing the transfer confirmation of the molten solder, and it is possible to obtain a reduction in cost.

### Brief Description of Drawings

[Fig. 1] Fig. 1 is a perspective view illustrating an electronic component mounting device which is an example of the present invention.
[Fig. 2] Fig. 2 is a plan view illustrating the electronic component mounting device of Fig. 1 as viewed from above.
[Fig. 3] Fig. 3 is a perspective view illustrating a line sensor with which the electronic component mounting device of Fig. 1 is provided.
[Fig. 4] Fig. 4 is a block diagram illustrating a control device with which the electronic component mounting device of Fig. 1 is provided.
[Fig. 5] Fig. 5 is a diagram illustrating an electronic component in a state in which molten solder is transferred to electrodes.
[Fig. 6] Fig. 6 is a graph illustrating a height of an electrode before the molten solder is transferred and a height of an electrode after the molten solder is transferred for every electrode.

### Description of Embodiments

Hereinafter, detailed description will be given of the example of the present invention with reference to the drawings as a mode for carrying out the present invention.

### <Configuration of Electronic Component Mounting Device>

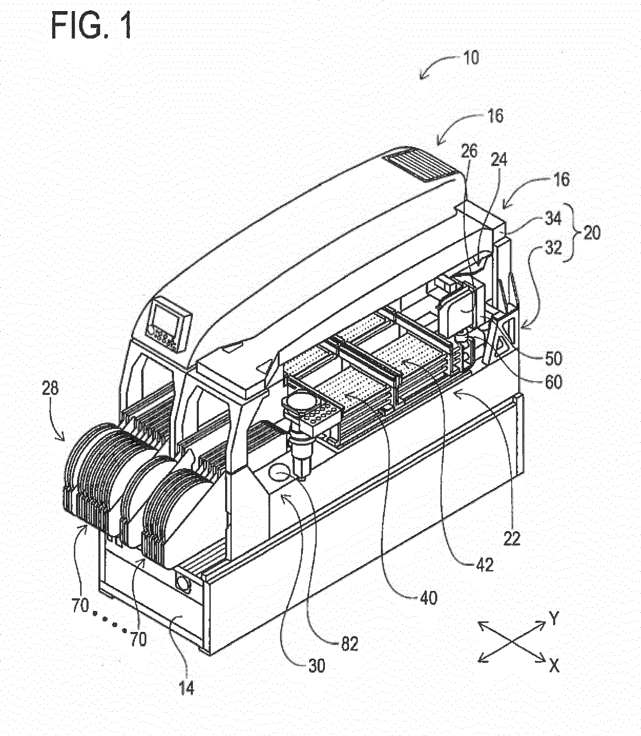

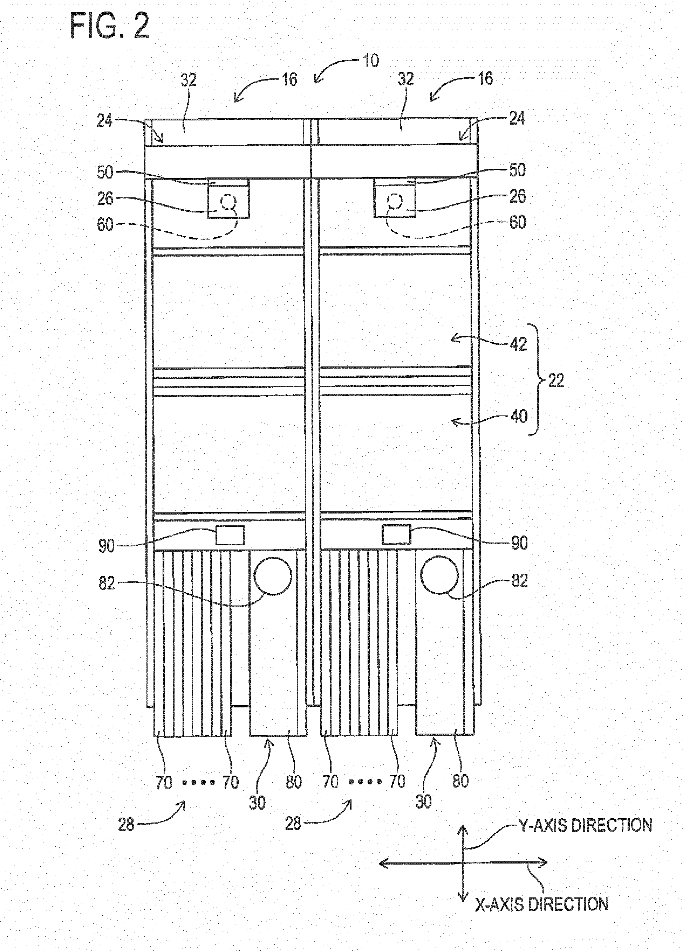

Fig. 1 and Fig. 2 illustrate an electronic component mounting device 10. Fig. 1 is a perspective view of the electronic component mounting device 10, and Fig. 2 is a plan view illustrating the electronic component mounting device 10 as viewed from above in a state in which a cover or the like is removed. The electronic component mounting device 10 is a device for mounting an electronic component on a circuit board. The electronic component mounting device 10 includes one system base 14, and two mounting machines 16 which are installed on the system base 14 to line up. Note that, in the following description, a direction in which the mounting machines 16 are lined up will be referred to as an X-axis direction, and a horizontal direction at a right angle to the X-axis direction will be referred to as a Y-axis direction.

Each of the mounting machines 16 is provided with a mounting machine main body 20, a conveyance device 22, a mounting head moving device (hereinafter, there are cases in which this is shortened to a "movement device") 24, a mounting head 26, a supply device 28, and a viscous fluid supply device 30. The mounting machine main body 20 is formed of a frame section 32, and a beam section 34 which bridges over the frame section 32.

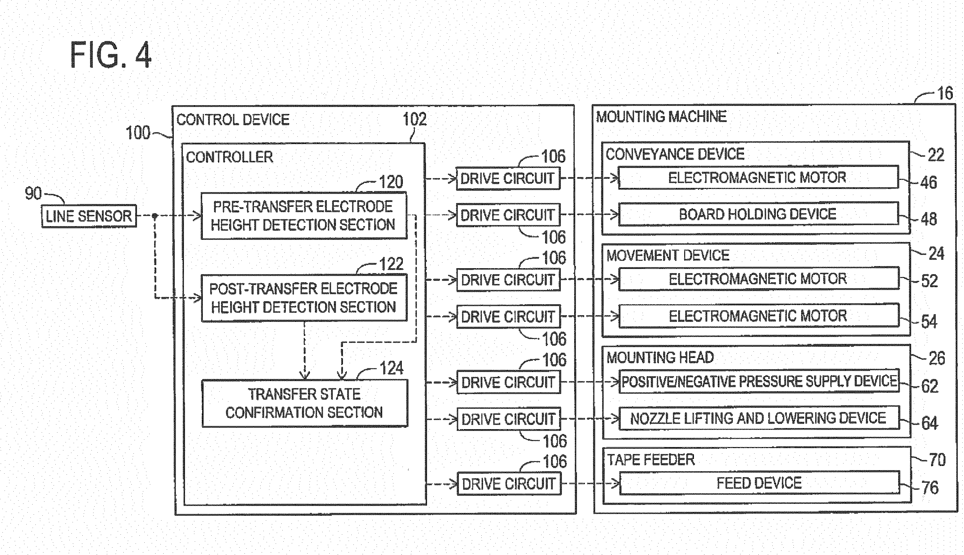

The conveyance device 22 is provided with two conveyor devices 40 and 42. The two conveyor devices 40 and 42 are installed on the frame section 32 to be parallel to each other and to extend in the X-axis direction. The two conveyor devices 40 and 42 convey circuit boards which are supported by the conveyor devices 40 and 42 in the X-axis direction using an electromagnetic motor (refer to Fig. 4) 46. The circuit board is held at a predetermined position in a fixed manner by a board holding device (refer to Fig. 4) 48.

The movement device 24 is an XY robot-type movement device. The movement device 24 is provided with an electromagnetic motor (refer to Fig. 4) 52 which causes a slider 50 to slide in the X-axis direction, and an electromagnetic motor (refer to Fig. 4) 54 which causes the slider 50 to slide in the Y-axis direction. The mounting head 26 is attached to the slider 50, and the mounting head 26 moves to an arbitrary position above the frame section 32 due to the operation of the two electromagnetic motors 52 and 54.

The mounting head 26 mounts the electronic component on the circuit board. The mounting head 26 includes a suction nozzle 60 which is provided on the bottom end surface of the mounting head 26. The suction nozzle 60 communicates with a positive/negative pressure supply device (refer to Fig. 4) 62 via negative air and positive air paths. The suction nozzle 60 vacuum holds the electronic component using a negative pressure and releases the held electronic component using a positive pressure. The mounting head 26 includes a nozzle lifting and lowering device (refer to Fig. 4) 64 which lifts and lowers the suction nozzle 60. The mounting head 26 changes the position of the held electronic component in the vertical direction using the nozzle lifting and lowering device 64.

The supply device 28 is a feeder-type supply device and is installed on the end portion of the front side of the frame section 32. The supply device 28 includes a tape feeder 70. The tape feeder 70 accommodates taped components in a wound state. The taped components are obtained by taping the electronic components. The tape feeder 70 feeds out the taped components using a feed device (refer to Fig. 4) 76. Accordingly, the feeder-type supply device 28 supplies the electronic components to the supplying position by feeding out the taped components. Note that, the tape feeder 70 can be attached to and detached from the frame section 32, and it is possible to adapt for the exchanging of the electronic components.

The viscous fluid supply device 30 is installed adjacent to the supply device 28. The viscous fluid supply device 30 includes a main body base 80 and a viscous fluid tray 82. The main body base 80 has a long shape and is installed on the end portion of the front side of the frame section 32 lined up with the tape feeder 70. The viscous fluid tray 82 is mounted on the top surface of the main body base 80, and molten solder is stored in the viscous fluid tray 82.

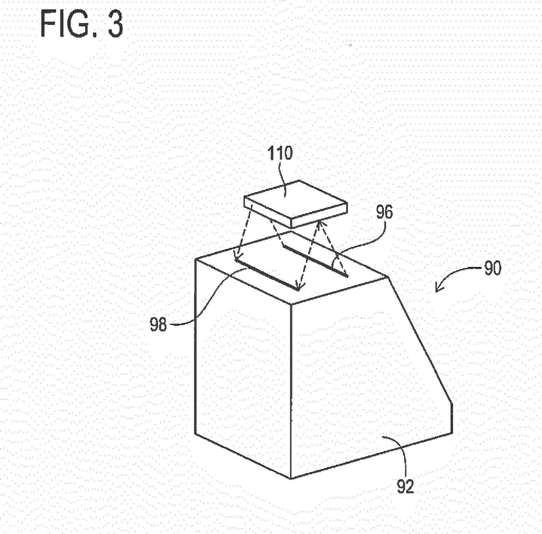

The mounting machine 16 is provided with a line sensor 90. As illustrated in Fig. 2, the line sensor 90 is installed between the supply device 28 and the conveyance device 22. As illustrated in Fig. 3, the line sensor 90 is formed of a main body section 92, an irradiation section 96, and a light receiving section 98. The irradiation section 96 is installed in a linear shape on the top surface of the main body section 92 and irradiates a measurement target with laser light. The light receiving section 98 receives the laser light which irradiates the measurement target from the irradiation section 96 and is reflected by the measurement target. The line sensor 90 detects the height of the measurement target based on the received laser light.

In the mounting machine 16, a coplanarity check is performed on the electronic component using the line sensor 90. The coplanarity check is a check of the height and damage of each electrode such as a bump of the electronic component, the flatness of the overall electrode, the degree of bending of the leads, and the like, and detects the heights of a plurality of electrodes of an electronic component using the line sensor 90. Specifically, the electronic component is held by the mounting head 26, and the electronic component is moved above the line sensor 90 due to the operation of the movement device 24. The mounting head 26 is moved in a direction perpendicular to the irradiation section 96 by operating the movement device 24 while performing the detection of the height of the electrodes using the line sensor 90. Accordingly, the heights of a plurality of electrodes of the electronic component are detected by the line sensor 90. Whether or not the detected heights of the plurality of electrodes are uniform is checked, and, when the heights of the plurality of electrodes are uniform, it is determined that the electronic component is valid, and when the heights are not uniform, it is determined that the electronic component is not valid. Note that, the resolution of the line sensor 90 in the vertical direction is 1 µm. In other words, the line sensor 90 is capable of detecting the height of the measurement target in 1 µm units. The detection width of the line sensor 90 is 40 mm. In other words, the line sensor 90 is capable of performing the coplanarity check of an electronic component which is less than or equal to 40 mm in one scan.

As illustrated in Fig. 4, the mounting machine 16 is provided with a control device 100. The control device 100 is provided with a controller 102 and a plurality of drive circuits 106. The plurality of drive circuits 106 are connected to the electromagnetic motors 46, 52, and 54, the board holding device 48, the positive/negative pressure supply device 62, the nozzle lifting and lowering device 64, and the feed device 76. The controller 102 is provided with a CPU, a ROM, a RAM, and the like, the main constituent of the controller 102 is a computer, and the controller 102 is connected to the plurality of drive circuits 106. Accordingly, the operations of the conveyance device 22, the movement device 24, and the like are controlled by the controller 102. The controller 102 is connected to the line sensor 90 and acquires the detection results which are obtained by the line sensor 90.

### <Mounting Work by Mounting Machine>

According to the configuration which is described above, in the mounting machine 16, it is possible to perform the mounting work on the circuit board which is held by the conveyance device 22 using the mounting head 26. Specifically, according to the instructions of the controller 102, the circuit board is conveyed to a working position, and at this position, is held in a fixed manner by the board holding device 48. The tape feeder 70 feeds the taped components and supplies the electronic components to the supplying position according to the instructions of the controller 102. The mounting head 26 moves above the supplying position of the electronic components and vacuum holds the electronic component using the suction nozzle 60 according to the instructions of the controller 102.

Subsequently, the mounting head 26 moves above the part camera (not illustrated) and the sucked electronic component is imaged according to the instructions of the controller 102 . The controller 102 acquires the error of the suction position based on the imaging data. Next, the mounting head 26 moves above the line sensor 90 and the coplanarity check described above is performed according to the instructions of the controller 102. When the coplanarity check determines that the electronic component is abnormal, the electronic component is discarded in a discarding box (not illustrated) . Meanwhile, when the coplanarity check determines that the electronic component is valid, the mounting head 26 moves above the viscous fluid tray 82 and the electronic component is lowered by the nozzle lifting and lowering device 64 according to the instructions of the controller 102. Accordingly, as illustrated in Fig. 5, molten solder 114 is transferred to electrodes 112 of an electronic component 110. The mounting head 26 moves above the circuit board, the error and the like of the suction position of the held electronic component is corrected, and the electronic component is mounted in a predetermined position on the circuit board according to the instructions of the controller 102.

### <Transfer Confirmation of Molten Solder to Electrodes>

As described above, in the mounting machine 16, the molten solder is transferred to the electrodes of the electronic component, and the electronic component is mounted on the circuit board. However, when the transferring of the molten solder to the electrodes is not appropriately performed, the electronic component may not be appropriately electrically connected to the circuit board and a faulty board may be produced. In light of this issue, in the mounting machine 16, the transfer confirmation of the molten solder to the electrodes is performed using the line sensor 90.

Specifically, after the molten solder is transferred to the electrodes of the electronic component, the mounting head 26 moves above the line sensor 90 and moves in a direction orthogonally intersecting the longitudinal direction of the irradiation section 96 according to the instructions of the controller 102. At this time, the line sensor 90 detects the heights of the plurality of electrodes 112 to which the molten solder is transferred according to the instructions of the controller 102. Accordingly, the controller 102 acquires the heights of the plurality of electrodes 112 after the transferring of the molten solder. In the coplanarity check, since the controller 102 has acquired the heights of the plurality of electrodes 112 before the transferring of the molten solder, the heights of the electrodes 112 before the transferring of the molten solder (hereinafter, there are cases in which this is shortened to the "pre-transfer electrode height") are compared with the heights of the electrodes 112 after the transferring of the molten solder (hereinafter, there are cases in which this is shortened to the "post-transfer electrode height").

When the post-transfer electrode height is greater than the pre-transfer electrode height according to the comparison between the pre-transfer electrode height and the post-transfer electrode height, it is determined that the molten solder is transferred to the electrodes 112. However, when the transfer amount of the molten solder to the electrodes 112 is too little, since this is a cause of faulty boards, it is necessary for a predetermined amount of the molten solder to be transferred to the electrodes 112. Therefore, in the mounting machine 16, when the post-transfer electrode height is greater than or equal to 1.1 times to 1.5 times the pre-transfer electrode height for all of the plurality of electrodes 112, it is determined that an appropriate amount of the molten solder is transferred to the electrodes 112.

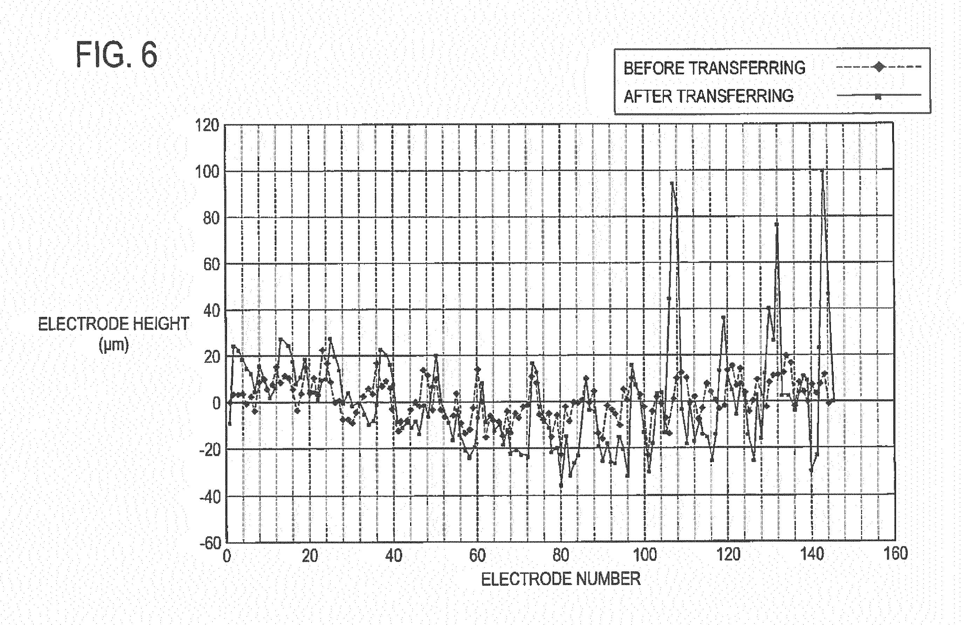

Hereinafter, description will be given of the specific transfer confirmation method. Fig. 6 illustrates the data obtained when performing the transfer confirmation on an electronic component which has approximately 150 of the electrodes 112. The horizontal axis of the graph illustrated in the diagram indicates the electrode number, and the vertical axis indicates the height (µm) of the electrode corresponding to the electrode number. Note that, a reference value (0 µm in the diagram) of the electrode height in the vertical axis is the average value of the pre-transfer electrode heights. The scanning speed of the electronic component when detecting the electrode height in the diagram, that is, the movement speed of the mounting head 26 due to the movement device 24 is 80 mm/s.

As can be understood from the diagram, in the electrodes 112 of approximately electrode numbers 1 to 105, the molten solder is not substantially transferred. In the electrodes 112 from electrode number 106 onward, although electrodes 112 in which the difference between the post-transfer electrode height and the pre-transfer electrode height is greater than or equal to 40 µm, that is, electrodes 112 to which molten solder of a thickness greater than or equal to 40 µm is transferred are present, there are also electrodes 112 in which the molten solder is not substantially transferred. Therefore, it is determined that the transferring of the molten solder to the electronic component has not been appropriately performed. The transferring of the molten solder to the electrodes 112 is performed again, and the stored amount of molten solder in the viscous fluid tray 82 is increased in order to transfer the appropriate amount of molten solder to the electrodes 112.

Specifically, the stored amount of molten solder in the viscous fluid tray 82 is increased such that the post-transfer electrode height is greater than or equal to 1.1 times to 1.5 times the pre-transfer electrode height. In other words, since the height of the electrode 112 which is used in the above measurement is 200 µm, molten solder is poured into the viscous fluid tray 82 such that the depth of the molten solder in the viscous fluid tray 82 is increased by approximately 20 µm to 100 µm. In this manner, by transferring the molten solder to the electrodes 112 using the viscous fluid tray 82 in which the stored amount is increased, it is possible to transfer the appropriate amount of molten solder to the electrodes 112. Note that, when there is data indicating that a sufficient amount of the molten solder, necessary for the application, is stored in the viscous fluid tray 82, the fiducial position of the application height when applying the viscous fluid to the electronic component which is held by the mounting head 26 is corrected in a downward direction.

In the mounting machine 16, the transfer confirmation of the molten solder to the electrodes 112 is performed using the line sensor 90, and the resolution of the detection by the line sensor 90 in the vertical direction is 1 µm. Accordingly, it is possible to precisely perform the transfer confirmation of the molten solder to the electrodes 112.

In the mounting machine 16, the transfer confirmation of the molten solder is performed using the line sensor 90 for performing the coplanarity check. Therefore, it is not particularly necessary to provide a sensor for performing the transfer confirmation of the molten solder, and it is economical.

Note that, as illustrated in Fig. 4, the controller 102 includes a pre-transfer electrode height detection section 120, a post-transfer electrode height detection section 122, and a transfer state confirmation section 124. The pre-transfer electrode height detection section 120 is a functional section for detecting the heights of the electrodes 112 before the molten solder is transferred. The post-transfer electrode height detection section 122 is a functional section for detecting the heights of the electrodes 112 after the molten solder is transferred. The transfer state confirmation section 124 is a functional section for confirming the transfer state of the molten solder to the electrodes 112 by comparing the electrode heights before the transferring of the molten solder and the electrode heights after the transferring of the molten solder.

Incidentally, in the example described above, the mounting machine 16 is an example of the electronic component mounting machine. The mounting head 26 is an example of the mounting head. The viscous fluid tray 82 is an example of the viscous fluid tray. The line sensor 90 is an example of the height sensor and the line sensor. The irradiation section 96 is an example of the irradiation section. The light receiving section 98 is an example of the light receiving section. The electronic component 110 is an example of the electronic component. The electrode 112 is an example of the electrode. The molten solder 114 is an example of the viscous fluid. The pre-transfer electrode height detection section 120 and the post-transfer electrode height detection section 122 are examples of the electrode height detection section. The transfer state confirmation section 124 is an example of the transfer state confirmation section. The step of detecting the pre-transfer electrode height using the pre-transfer electrode height detection section 120 is an example of the pre-transfer electrode height detection step. The step of detecting the post-transfer electrode height using the post-transfer electrode height detection section 122 is an example of the post-transfer electrode height detection step. The step of confirming the transfer state of the molten solder to the electrodes 112 using the comparison between the pre-transfer electrode heights and the post-transfer electrode heights is an example of the transfer confirmation step.

Note that, the present invention is not limited to the example described above, and it is possible to carry out the present invention in various modes subjected to various modifications and improvements based on the knowledge of a person skilled in the art. Specifically, for example, in the example described above, the transfer confirmation of the molten solder to the electrodes 112 is performed using the line sensor 90; however, as long as the sensor is capable of detecting the heights of the electrodes 112, it is possible to use various height sensors such as a 3D sensor.

In the example described above, transfer confirmation of molten solder is performed; however, it is also possible to perform transfer confirmation of another viscous fluid to an electrode.

### Reference Signs List

16: mounting machine, 26: mounting head, 82: viscous fluid tray, 90: line sensor, 96: irradiation section, 98: light receiving section, 110: electronic component, 112: electrode, 114: molten solder (viscous fluid), 120: pre-transfer electrode height detection section (electrode height detection section), 122: post-transfer electrode height detection section (electrode height detection section), 124: transfer state confirmation section.

## Claims

1. An electronic component mounting machine (16) which is configured to mount an electronic component (110), to an electrode (112) of which a viscous fluid (114) is transferred, on a circuit board, the electronic component mounting machine (16) comprising:
a mounting head (26) configured to hold the electronic component (110);
a viscous fluid tray (82) for storing the viscous fluid (114) and transferring the viscous fluid (114) to the electrode (112) of the electronic component (110) which is held by the mounting head (26);
a height sensor (90) capable of detecting a height of the electrode (112) of the electronic component (110) which is held by the mounting head (26);
an electrode height detection section (120, 122) configured to detect a pre-transfer electrode height which is the height of the electrode (112) before transferring of the viscous fluid (114) and a post-transfer electrode height which is the height of the electrode (112) after transferring of the viscous fluid (114) using the height sensor (90); and
a transfer state confirmation section (124) configured to confirm a transfer state of the viscous fluid (114) to the electrode (112) by comparing the pre-transfer electrode height and the post-transfer electrode height which are detected by the electrode height detection section (120, 122),
**characterized in that**
the height sensor (90) is a line sensor which includes
an irradiation section (96) installed in a linear shape configured to irradiate a measurement target with laser light in a linear manner, and
a light receiving section (98) configured to receive the light which irradiates the measurement target from the irradiation section (96) and is reflected by the measurement target.

2. The electronic component mounting machine (16) according to Claim 1,
wherein the height sensor (90) is a sensor for performing a coplanarity check on the electronic component (110).

3. A transfer confirmation method which confirms a transfer state of a viscous fluid (114) to an electrode (112) in an electronic component mounting machine (16) which mounts an electronic component (110), to the electrode (112) of which a viscous fluid (114) is transferred, on a circuit board, the electronic component mounting machine (16) comprising:
a mounting head (26) which holds the electronic component (110); and
a viscous fluid tray (82) for storing the viscous fluid (114) and transferring the viscous fluid (114) to the electrode (112) of the electronic component (110) which is held by the mounting head (26),
wherein the transfer confirmation method includes
a pre-transfer electrode height detection step of detecting a height of the electrode (112) before transferring of the viscous fluid (114) using a height sensor (90) capable of detecting the height of the electrode (112) of the electronic component (110) which is held by the mounting head (26),
a post-transfer electrode height detection step of detecting the height of the electrode (114) after transferring of the viscous fluid (114) using the height sensor (90), and
a transfer confirmation step of confirming the transfer state of the viscous fluid (114) to the electrode (112) by comparing the height of the electrode (112) which is detected in the pre-transfer electrode height detection step and the height of the electrode (112) which is detected in the post-transfer electrode height detection step,
**characterized in that**
the height sensor (90) is a line sensor (90) which includes
an irradiation section (96) which is installed in a linear shape and irradiates a measurement target with laser light in a linear manner, and
a light receiving section (98) which receives the light which irradiates the measurement target from the irradiation section (96) and is reflected by the measurement target.

## Patentansprüche

1. Maschine (16) zum Bestücken mit elektronischen Bauteilen, die so eingerichtet ist, dass sie eine Leiterplatte mit einem elektronischen Bauteil (110) bestückt, wobei zu einer Elektrode (112) desselben ein viskoses Fluid (114) übertragen wird, und die Maschine (16) zum Bestücken mit elektronischen Bauteilen umfasst:
einen Bestückungs-Kopf (26), der so eingerichtet ist, dass er das elektronische Bauteil (110) hält;
einen Behälter (82) für viskoses Fluid zum Speichern des viskosen Fluids (114) und zum Übertragen des viskosen Fluids (114) zu der Elektrode (112) des elektronischen Bauteils (110), das von dem Bestückungs-Kopf (26) gehalten wird,
einen Höhen-Sensor (90), der eine Höhe der Elektrode (112) des elektronischen Bauteils (110) erfassen kann, das von dem Bestückungs-Kopf (26) gehalten wird;
einen Teilabschnitt (120, 122) zur Erfassung einer Elektroden-Höhe, der so eingerichtet ist, dass er eine Elektroden-Höhe vor Übertragung, die die Höhe der Elektrode (112) vor dem Übertragen des viskosen Fluids (114) ist, sowie eine Elektroden-Höhe nach Übertragung, die eine Höhe der Elektrode (112) nach dem Übertragen des viskosen Fluids (114) ist, unter Verwendung des Höhen-Sensors (90) erfasst; und
einen Teilabschnitt (124) zur Prüfung eines Übertragungs-Zustandes, der so eingerichtet ist, dass er einen Übertragungs-Zustand des viskosen Fluids (114) zu der Elektrode (112) prüft, indem er die Elektroden-Höhe vor Übertragung und die Elektroden-Höhe nach Übertragung vergleicht, die von dem Teilabschnitt (120, 122) zur Erfassung einer Elektroden-Höhe erfasst werden,
**dadurch gekennzeichnet, dass**
der Höhen-Sensor (90) ein Linien-Sensor ist, der enthält:
einen Bestrahlungs-Teilabschnitt (96), der in einer linearen Form installiert ist und so eingerichtet ist, dass er ein Messungs-Objekt linear mit Laserlicht bestrahlt, sowie
einen Lichtempfangs-Teilabschnitt (98), der so eingerichtet ist, dass er das Licht empfängt, mit dem das Messungs-Objekt von dem Bestrahlungs-Teilabschnitt (96) bestrahlt wird und das von dem Messungs-Objekt reflektiert wird.

2. Maschine (16) zum Bestücken mit elektronischen Bauteilen nach Anspruch 1,
wobei der Höhen-Sensor (90) ein Sensor zum Durchführen einer Prüfung auf Koplanarität an dem elektronischen Bauteil (110) ist.

3. Verfahren zur Prüfung von Übertragung, mit dem ein Übertragungs-Zustand eines viskosen Fluids (114) zu einer Elektrode (112) in einer Maschine (16) zum Bestücken mit elektronischen Bauteilen geprüft wird, die eine Leiterplatte mit einem elektronischen Bauteil (110) bestückt, wobei zu einer Elektrode (112) desselben ein viskoses Fluid (114) übertragen wird, und die Maschine (16) zum Bestücken mit elektronischen Bauteilen umfasst:
einen Bestückungs-Kopf (26), der das elektronische Bauteil (110) hält; sowie
einen Behälter (82) für viskoses Fluid zum Speichern des viskosen Fluids (114) und zum Übertragen des viskosen Fluids (114) zu der Elektrode (112) des elektronischen Bauteils (116), das von dem Bestückungs-Kopf (26) gehalten wird,
und das Verfahren zur Prüfung von Übertragung einschließt:
einen Schritt zur Erfassung einer Elektroden-Höhe vor Übertragung, in dem eine Höhe der Elektrode (112) vor dem Übertragen des viskosen Fluids (114) unter Verwendung eines Höhen-Sensors (90) erfasst wird, der die Höhe der Elektrode (112) des elektronischen Bauteils (110) erfassen kann, das von dem Bestückungs-Kopf (26) gehalten wird,
einen Schritt zur Erfassung einer Elektroden-Höhe nach Übertragung, in dem die Höhe der Elektrode (114) nach dem Übertragen des viskosen Fluids (114) unter Verwendung des Höhen-Sensors (90) erfasst wird, sowie
einen Schritt zur Prüfung von Übertragung, in dem der Übertragungs-Zustand des viskosen Fluids (114) zu der Elektrode (112) geprüft wird, indem die Höhe der Elektrode (112), die in dem Schritt zur Erfassung einer Elektroden-Höhe vor Übertragung erfasst wird, und die Höhe der Elektrode (112) verglichen werden, die in dem Schritt zur Erfassung einer Elektroden-Höhe nach Übertragung erfasst wird,
**dadurch gekennzeichnet, dass**
der Höhen-Sensor (90) ein Linien-Sensor (90) ist, der enthält:
einen Bestrahlungs-Teilabschnitt (96), der in einer linearen Form installiert ist und ein Messungs-Objekt linear mit Laserlicht bestrahlt, sowie
einen Lichtempfangs-Teilabschnitt (98), der das Licht empfängt, mit dem das Messungs-Objekt von dem Bestrahlungs-Teilabschnitt (96) bestrahlt wird und das von dem Messungs-Objekt reflektiert wird.

## Revendications

1. Machine (16) de montage de composant électronique qui est configurée pour monter un composant électronique (110), sur une électrode (112) duquel un fluide visqueux (114) est transféré, sur une carte de circuit imprimé, la machine (16) de montage de composant électronique comprenant :
une tête de montage (26) conçue pour maintenir le composant électronique (110) ;
un plateau de fluide visqueux (82) permettant de stocker le fluide visqueux (114) et de transférer le fluide visqueux (114) sur l'électrode (112) du composant électronique (110) qui est maintenu par la tête de montage (26) ;
un capteur de hauteur (90) pouvant détecter une hauteur de l'électrode (112) du composant électronique (110) qui est maintenu par la tête de montage (26) ;
une section (120, 122) de détection de hauteur d'électrode configurée pour détecter une hauteur d'électrode avant transfert qui est la hauteur de l'électrode (112) avant le transfert du fluide visqueux (114) et une hauteur d'électrode après transfert qui est la hauteur de l'électrode (112) après le transfert du fluide visqueux (114), au moyen du capteur de hauteur (90) ; et
une section (124) de confirmation d'état de transfert configurée pour confirmer un état de transfert du fluide visqueux (114) sur l'électrode (112) en comparant la hauteur d'électrode avant transfert et la hauteur d'électrode après transfert qui sont détectées par la section (120, 122) de détection de hauteur d'électrode,
**caractérisée en ce que**
le capteur de hauteur (90) est un capteur linéaire qui inclut
une section d'irradiation (96) agencée sous une forme linéaire, configurée pour irradier une cible de mesure avec de la lumière laser d'une manière linéaire, et
une section de réception de lumière (98) configurée pour recevoir la lumière qui est émise par la section d'irradiation (96) et irradie la cible de mesure et qui est réfléchie par la cible de mesure.

2. Machine (16) de montage de composant électronique selon la revendication 1,
dans laquelle le capteur de hauteur (90) est un capteur permettant d'effectuer un contrôle de coplanarité sur le composant électronique (110).

3. Procédé de confirmation de transfert qui confirme un état de transfert d'un fluide visqueux (114) sur une électrode (112) dans une machine (16) de montage de composant électronique qui monte un composant électronique (110), sur l'électrode (112) duquel un fluide visqueux (114) est transféré, sur une carte de circuit imprimé, la machine (16) de montage de composant électronique comprenant :
une tête de montage (26) qui maintient le composant électronique (110) ; et
un plateau de fluide visqueux (82) permettant de stocker le fluide visqueux (114) et de transférer le fluide visqueux (114) sur l'électrode (112) du composant électronique (110) qui est maintenu par la tête de montage (26),
le procédé de confirmation de transfert comprenant
une étape de détection de hauteur d'électrode avant transfert consistant à détecter une hauteur de l'électrode (112) avant le transfert du fluide visqueux (114) au moyen d'un capteur de hauteur (90) pouvant détecter la hauteur de l'électrode (112) du composant électronique (110) qui est maintenu par la tête de montage (26),
une étape de détection de hauteur d'électrode après transfert consistant à détecter la hauteur de l'électrode (112) après le transfert du fluide visqueux (114) au moyen du capteur de hauteur (90), et
une étape de confirmation de transfert consistant à confirmer l'état de transfert du fluide visqueux (114) sur l'électrode (112) en comparant la hauteur de l'électrode (112) qui est détectée dans l'étape de détection de hauteur d'électrode avant transfert à la hauteur de l'électrode (112) qui est détectée dans l'étape de détection de hauteur d'électrode après transfert,
**caractérisé en ce que**
le capteur de hauteur (90) est un capteur linéaire (90) qui inclut
une section d'irradiation (96) qui est agencée sous une forme linéaire et irradie une cible de mesure avec de la lumière laser d'une manière linéaire, et
une section de réception de lumière (98) qui reçoit la lumière qui est émise par la section d'irradiation (96) et irradie la cible de mesure et qui est réfléchie par la cible de mesure.
